# EUROPÄISCHE PATENTSCHRIFT

(11) **EP 3 070 401 B1**
(45) Veröffentlichungstag und Bekanntmachung des Hinweises auf die Patenterteilung: **04.10.2017**
(21) Anmeldenummer: 15159093.2
(22) Anmeldetag: 13.03.2015
(51) Int. Cl.: F21V 27/02, F21V 31/00, F21V 31/04, F21V 23/06, H01L 33/56, F21Y 115/10, F21Y 105/10

(54) **BELEUCHTUNGSVORRICHTUNG**
ILLUMINATION DEVICE
DISPOSITIF D'ÉCLAIRAGE

(43) Veröffentlichungstag der Anmeldung: 21.09.2016
(73) Patentinhaber: Lunux GmbH, 30880 Laatzen (DE)
(72) Erfinder: Kerpe, Alexander, 59555 Lippstadt (DE); Möller, Dennis, 59556 Lippstadt (DE)
(74) Vertreter: Jöstingmeier, Martin

(56) Entgegenhaltungen:
- EP-A1- 2 317 206
- EP-A1- 2 857 744
- WO-A1-2014/019953
- DE-A1-102008 034 294
- DE-U1- 20 015 359
- JP-A- 2004 111 284

## Beschreibung

Die Erfindung betrifft eine Beleuchtungsvorrichtung mit einem Lichtmodul umfassend einen mindestens teilweise ummantelten Schaltungsträger, welcher mindestens eine an dem Schaltungsträger festgelegte Leuchtdiode als Lichtquelle und mindestens eine der mindestens einen Leuchtdiode zugeordnete Linse zum Formen einer Lichtverteilung aufweist, und umfassend ein an dem Schaltungsträger vorgesehenes elektrisches Anschlussmodul, wobei an dem Schaltungsträger mindestens eine Zuleitung vorgesehen ist zum Verbinden der mindestens einen Leuchtdiode mit dem elektrischen Anschlussmodul, und mit einer an das Lichtmodul angelegten Abdeckung, welche einen transparenten Lichtdurchlassabschnitt für das von der mindestens einen Leuchtdiode abgestrahlte Licht aufweist.

Bekannt sind Beleuchtungsvorrichtungen in modularer Bauform, welche ein Lichtmodul und eine an das Lichtmodul angesetzte Abdeckung aufweisen. Beispielsweise ist ein Lichtmodul mit einer Platine als Schaltungsträger und einer Mehrzahl von an der Platine beabstandet festgelegten Leuchtdioden als Lichtquellen aus der WO 2007/064701 A1 bekannt. Die Platine weist eine Ummantelung aus einem thermisch leitfähigen Material mit einer Schmelztemperatur von 100° C und einer Thermoleitfähigkeit von 1 W/m²K oder mehr auf. Die Ummantelung ist lokal im Bereich der Leuchtdioden und eines Anschlusskontakts ausgespart beziehungsweise unterbrochen ausgebildet. Eine vollständige Kapselung im Sinne eines Berührungsschutzes beziehungsweise eines Schutzes vor einem Eintrag von Fremdstoffen und Schmutz ist durch die Ummantelung nicht realisiert.

Aus der EP 1 657 758 A1 ist ein Lichtmodul mit einem Schaltungsträger und dran festgelegten Leuchtdioden bekannt. Den Leuchtdioden sind in einem Tauchverfahren aus Silikon hergestellte Einzellinsen zugeordnet. Eine vollständige oder teilweise Ummantelung des Schaltungsträgers, insbesondere aus Silikon, ist nicht offenbart.

WO 2014/019953 A offenbart ein Lichtmodul, mit einem Schaltungsträger auf dem LEDS sitzen. In Abstrahlrichtung vor den LEDs ist eine transparente Frontabdeckung, die in ihrem Randbereich einen umlaufenden Graben ausbildet. Um den Schaltungsträger wasserdicht mit der Frontscheibe zu einem Lichtmodul zu verbinden wird der Randbereich mit einem Kunststoff der dabei einen Graben der Abdeckung ausfüllt.

Auch EP 2 317 206 A betrifft ein LED-Leuchtmodul, bei dem ähnlich wie nach der WO 2014/019953 Teile des Leuchtmoduls durch Umspritzen miteinander verbunden werden. Vor jeder LED wird je eine Abdeckung angeordnet, um diese während des nachfolgenden Umspritzens sowohl mechanisch als auch thermisch zu schützen. Beim Umspritzen wird das Gehäuse geformt.

DE 200 15 359 U1 offenbart ein Dichtprofil zur Abdichtung eines Gehäuses gegenüber einer Abschlussscheibe einer Leuchte. Das Dichtprofil greift im montierten Zustand in eine Nut des Gehäuses ein und wird in seitlich an dem Dichtprofil angeordnete Haltelippen fixiert. Zur Abdichtung gegenüber dem Gehäuse sitzt in einer Ausnehmung der Dichtlippe ein Dichtstrang.

JP 2004 111284A betrifft eine wasserdichte Gebäudelampe mit einem Gehäuse, das einen Rahmen für eine Glasscheibe aufweist. Der Randbereich der Glasscheibe wird von einem Dichtprofil 5 umgriffen.

DE 10 2008 034 294 A1 offenbart eine Tunnelleuchte mit einem Gehäuse mit einem Abdeckrahmen zur Aufnahme einer Glasabdeckung. Zwischen dem Abdeckrahmen und einem mit dem Abdeckrahmen in Eingriff stehenden Gehäuserand ist eine umlaufende Doppeldichtung.

Nach der EP2857744A1 wird ein mit LEDs bestückter Schaltungsträger durch eine am Rand des Schaltungsträgers angeordnete Dichtung mit einer in Abstrahlrichtung vor den LEDs angeordneten transparenten Abdeckung mechanisch verbunden.

Aufgabe der vorliegenden Erfindung ist es insofern, eine Beleuchtungsvorrichtung in Richtung geringer Herstellkosten und verbesserter Montageeigenschaften weiterzuentwickeln.

Zur Lösung der Aufgabe ist die Erfindung durch ein Leuchtmodul mit den Merkmalen des Anspruchs 1 gekennzeichnet. Bevorzugt sieht das Lichtmodul zwei oder mehr Leuchtdioden und eine korrespondierenden Anzahl von Linsen vor.

Der besondere Vorteil der Erfindung besteht darin, dass die Silikonumspritzung für den Schaltungsträger diesen vor Kontakt beziehungsweise Verunreinigung schützt und zugleich eine mechanische Schnittstelle zum Festlegen des Lichtmoduls in der Beleuchtungsvorrichtung definiert. Die als Teil der Silikonumspritzung realisierte Dichtwulst kapselt zum einen einen zwischen dem Lichtmodul und der Abdeckung gebildeten, die Leuchtdioden aufnehmenden Innenraum und sorgt durch die infolge der elastischen Verformung an der Dichtwulst auftretenden Fügekräfte für eine ausreichende mechanische Verbindung des Anschlussmoduls mit dem Lichtmodul. Indem die Nut und die in die Nut eingesetzte Dichtwulst umlaufend gestaltet sind, verteilen sich die Kräfte gleichmäßig.

Nach einer bevorzugten Ausführungsform der Erfindung ist die Dichtwulst im Querschnitt V-förmig ausgebildet, wobei zwei Schenkel der Dichtwulst in einem Verbindungspunkt derselben einen Scheitel definieren, welcher im montierten Zustand dem Nutgrund zugewandt ist. Vorteilhaft verbessert sich die Montagefähigkeit weiter durch die V-Form der Dichtwulst. Die zueinander angestellten Schenkel wirken wie Montageschrägen, welche ein leichtes Ansetzen des Lichtmoduls an die Abdeckung und eine Selbstzentrierung im Zuge der Montage begünstigen. Die V-Form mit den zwei abgewinkelten Schenkeln erhöht darüber hinaus die Elastizität der aus Silikonmaterial hergestellten Dichtwulst weiter.

Nach einer Weiterbildung der Erfindung verjüngt sich ein Nutquerschnitt in Richtung des Nutgrunds. Beispielsweise ist die Nut im Querschnitt V-förmig ausgebildet. Vorteilhaft begünstigt die spezifische Nutgeometrie die Montage. Die Verbindungskräfte werden gleichmäßig und über eine große Fläche an den Nutflanken abstützt, so dass einer Beschädigung beziehungsweise unzulässigen Belastung der Dichtwulst vorgebeugt ist. Weiter verbessert sich die Dichtwirkung durch eine möglichst große Berührungsfläche zwischen der Dichtwulst und den Flanken der Nut.

Nach einer Weiterbildung der Erfindung sind die gegenüberliegenden Nutflanken jedenfalls abschnittsweise flach beziehungsweise eben ausgebildet. Die flache beziehungsweise ebene Geometrie der Nutflanken begünstigt die Montage und eine gleichmäßige Dichtwirkung.

Nach einer Weiterbildung der Erfindung ist im montierten Zustand der Scheitel der Dichtwulst beabstandet zum Nutgrund vorgesehen. Vorteilhaft wird durch das Vorsehen eines Abstands zwischen Nutgrund und Scheitel gewährleistet, dass die Dichtwulst ausreichend tief in die Nut eindringt und eine definierte Dichtung im Bereich der Nutflanken realisiert ist. Bei einem V-förmigen Querschnitt der Dichtwulst kann insbesondere vorgesehen sein, dass die Schenkel an den zwei gegenüberliegenden Nutflanken flächig anliegen, während eine Berührung von Scheitel und Nutgrund vermieden ist.

Nach einer Weiterbildung der Erfindung ist die Dichtwulst im Querschnitt U-förmig gebildet. Die Dichtwulst des Lichtmoduls nimmt einen an der Abdeckung gebildeten Steg zwischen zwei einander gegenüberliegenden Schenkeln auf. Dichtlippen, welche an den Schenkeln vorgesehen sind, sind bevorzugt an einer Innenseite der Schenkel dem jeweils gegenüberliegenden Schenkel zugewandt ausgebildet.

Der Schaltungsträger des Lichtmoduls besteht bevorzugt aus einem wärmeleitfähigen Material. Beispielsweise werden Metallkern-Leiterplatten als Schaltungsträger verwendet. Auf den Schaltungsträger werden die Leuchtdioden bevorzugt aufgelötet. Neben den Leuchtdioden können an dem Schaltungsträger als weitere Funktionskomponenten Temperatur- beziehungsweise Lichtsensoren oder dem Überspannungsschutz dienende Funktionskomponenten vorgesehen sein.

Eine Kontaktierung des Schaltungsträgers mit den darauf vorgesehenen Leuchtdioden und bevorzugt den weiteren Schaltungskomponenten erfolgt insbesondere über das elektrische Anschlussmodul, welches beispielsweise einen an dem Schaltungsträger festgelegten Steckverbinder und eine Mehrzahl von Leitern aufweist, wobei die Leiter zu einem Kabel verbunden sein können und mit dem Steckverbinder kontaktiert sind. Beispielsweise können Leiter des Kabels direkt mit dem Schaltungsträger verbunden sein, insbesondere mittels Löten. Ebenso kann eine gedichtete Steckbuchse vorgesehen werden, in die eine Treiberelektronik mit einem korrespondierenden Gegenstecker eingesetzt werden kann. Auf ein Kabel kann dann verzichtet werden.

Der Schaltungsträger ist im Bereich einer Außenseite mit Silikon umspritzt. Insbesondere ist die Silikonumspritzung im Bereich einer Vorderseite des Schaltungsträgers, welche die Leuchtdioden aufweist, im Bereich einer gegenüberliegenden Rückseite und an den die Vorderseite und die Rückseite verbindenden Kantenflächen vorgesehen. Zur Herstellung der Silikonumspritzung wird bevorzugt sogenanntes Flüssig-Silikon (liquid silicone rubber, LSR) verwendet. Die Verarbeitung erfolgt als flüssiges 2-Komponenten-Material in Spritzgießmaschinen. Die flüssige 2-Komponenten-Masse wird in einem Werkzeug der Spritzgießmaschine bei zirka 150°C ausgehärtet. Die Dauer des Härtevorgangs liegt typischerweise zwischen einigen Sekunden und wenigen Minuten, abhängig insbesondere von der Materialmenge und der Materialstärke. Das zur Herstellung der Silikonumspritzung vorzugsweise verwendete Material hat eine Transmission von mehr als 90 % im sichtbaren Spektralbereich, eine Eintrübung (sogenannter Hazewert) von weniger als 4 % im sichtbaren Spektralbereich und eine hohe UV-Beständigkeit. Das Silikon bietet eine hohe Temperaturbeständigkeit auch bei Temperaturen von beispielsweise 150°C und eine hohe elektrische Durchschlagfestigkeit von mehr als 10 kV/mm. Die hohe elektrische Durchschlagfestigkeit sorgt insbesondere für eine gute Isolationseigenschaft der Silikonumspritzung.

Die Wärmeleitfähigkeit der Silikonumspritzung beträgt typischerweise weniger als 1,5 W/m K. Nach einer bevorzugten Ausführungsform der Erfindung ist die Wärmeleitfähigkeit kleiner als 0,5 W/m K. Um gleichwohl eine ausreichende Abfuhr der Wärme zu gewährleisten, ist eine Dicke der Silikonumspritzung insbesondere im Bereich der Rückseite kleiner als 1,5 mm und bevorzugt kleiner als 1 mm. Die geringe Dicke führt zugleich zu einem geringen Materialeinsatz und damit zu geringen Kosten für das Lichtmodul.

Als Leuchtdiode kann beispielsweise eine handelsübliche High Power-LED mit Primäroptik vorgesehen werden. Bevorzugt werden jedoch Leuchtdioden ohne Primäroptik verwendet. Der Leistungsbereich der verwendeten Leuchtdioden liegt typischerweise bei 1 W bis 10 W oder mehr. Durch den Verzicht auf die Primäroptik sind die Leuchtdioden besonders kostengünstig. Zugleich ergibt sich eine hohe optische Güte beziehungsweise Effizienz, da die Silikonlinsen beim Umspritzen der Leuchtdiode wie eine Primäroptik wirken und sich die optischen Eigenschaften der ohne Primäroptik verbauten Leuchtdiode an denen einer Leuchtdiode mit Primäroptik angleichen.

Nach einer Weiterbildung der Erfindung können sogenannte Chip Size-Leuchtdioden verwendet werden, welche nur aus dem Halbleitermaterial, elektrischen Kontaktflächen und einer dünnen Phosphorschicht bestehen und auf eine Primäroptik ebenso verzichten wie auf einen keramischen Träger. Hierdurch reduzieren sich die Kosten der Leuchtdioden weiter. Ein Schutz der Chip Size-Leuchtdioden gegen Umwelteinflüsse wird dann durch die Silikonumspritzung im ausreichenden Maße gewährleistet. Zudem ergibt sich eine vorteilhaft geringe Bauhöhe für das Lichtmodul, so dass insbesondere die Integration in eine Beleuchtungsvorrichtung vereinfacht wird.

Eine Dicke der Silikonumspritzung ist im Bereich der Vorderseite dort, wo keine Linsen ausgeformt sind, bevorzugt kleiner als 1 mm und besonders bevorzugt kleiner oder gleich einer Bauhöhe der Leuchtdioden.

Aus den weiteren Unteransprüchen und der nachfolgenden Beschreibung sind weitere Vorteile, Merkmale und Einzelheiten der Erfindung zu entnehmen. Dort erwähnte Merkmale können jeweils einzeln für sich oder auch in beliebiger Kombination erfindungswesentlich sein. Die Zeichnungen dienen lediglich beispielhaft der Klarstellung der Erfindung und haben keinen einschränkenden Charakter.

Anhand der beigefügten Zeichnungen wird die Erfindung nachfolgend näher erläutert. Dabei zeigen:
- Fig. 1: eine perspektivische Ansicht eines Lichtmoduls und eine dem Lichtmodul zugeordnete Abdeckung von einer Vorderseite,
- Fig. 2: das Lichtmodul und die Abdeckung nach Fig. 1 von einer perspektivischen Rückseitenansicht,
- Fig. 3: eine Prinzipdarstellung eines Schaltungsträgers und einer Silikonumspritzung des Lichtmoduls nach Fig. 1,
- Fig. 4: einen Querschnitt durch das Lichtmodul und die Abdeckung nach Fig. 1,
- Fig. 5: einen Querschnitt durch das Lichtmodul und die Abdeckung nach Fig. 4 in einer Montageposition,
- Fig. 6: eine Detailvergrößerung eines Anschlussmoduls des Lichtmoduls vor dem Umspritzen,
- Fig. 7: das Anschlussmodul nach Fig.6 mit einer durch die Silikonumspritzung definierten Anschlussabdeckung,
- Fig. 8: eine Aufsicht auf die Abdeckung,
- Fig. 9: einen Schnitt D-D durch die Abdeckung nach Fig. 8,
- Fig. 10: eine Detailansicht der Silikonumspritzung im Bereich einer Zugentlastung für das Anschlussmodul,
- Fig. 11: eine Detailansicht der korrespondierend gestalteten Dichtungsgeometrie an der Silikonumspritzung und der Abdeckung vor der Montage,
- Fig. 12: eine Detailansicht der Dichtung gemäß Fig. 11 nach der Montage,
- Fig. 13: eine Aufsicht auf eine als Teil der Silikonumspritzung ausgebildeten Linse,
- Fig. 14: einen Schnitt B-B durch die Linse der Silikonumspritzung nach Fig. 13,
- Fig. 15: eine perspektivische Ansicht der Beleuchtungsvorrichtung mit dem Lichtmodul, der Abdeckung und einem das Lichtmodul aufnehmenden Gehäuse und
- Fig. 16: einen Querschnitt durch die Beleuchtungsvorrichtung nach Fig. 15.

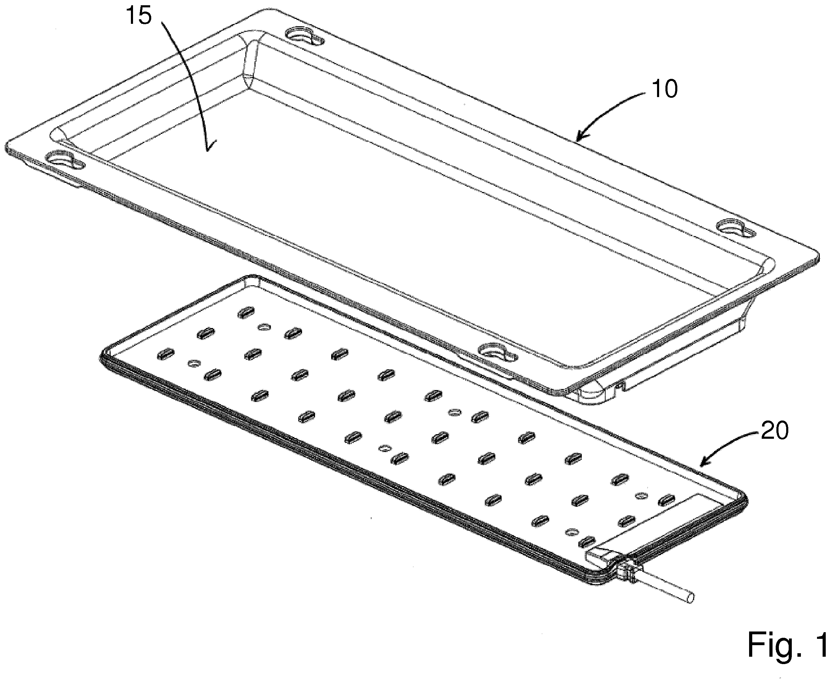

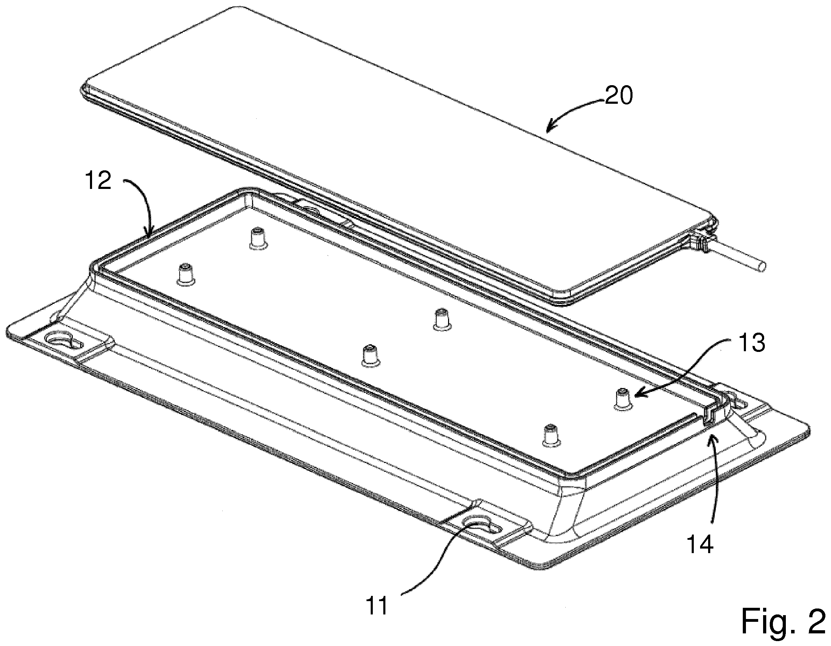

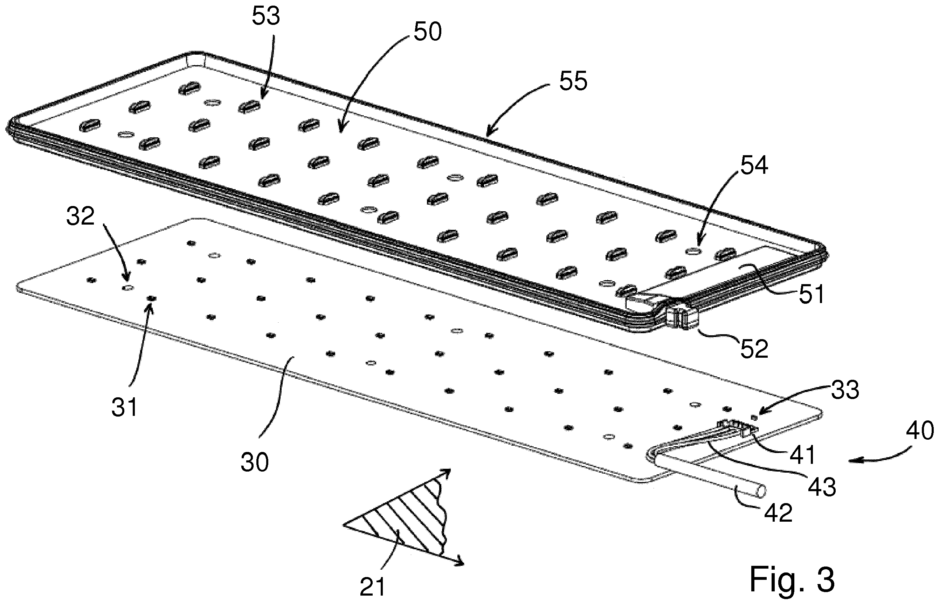

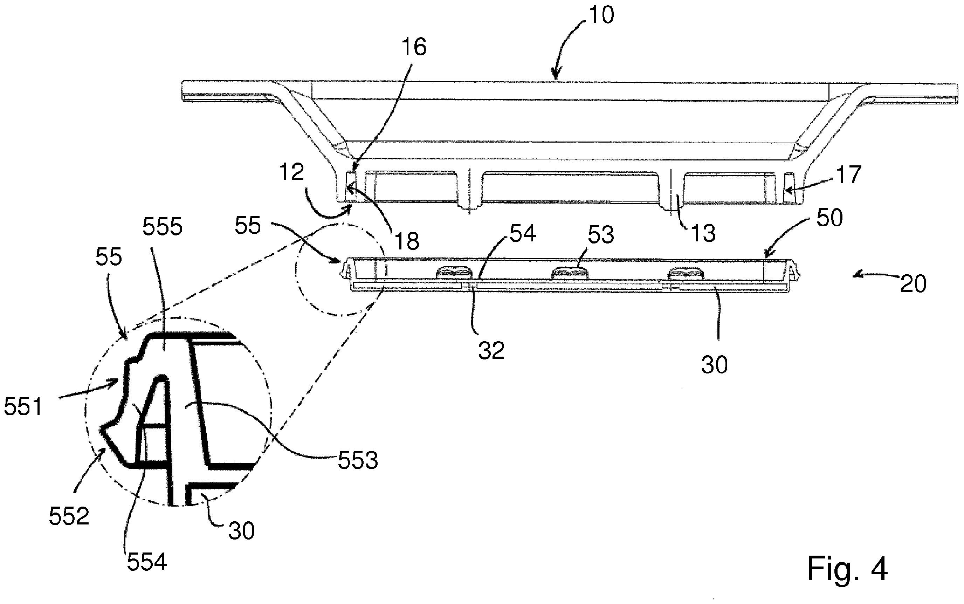

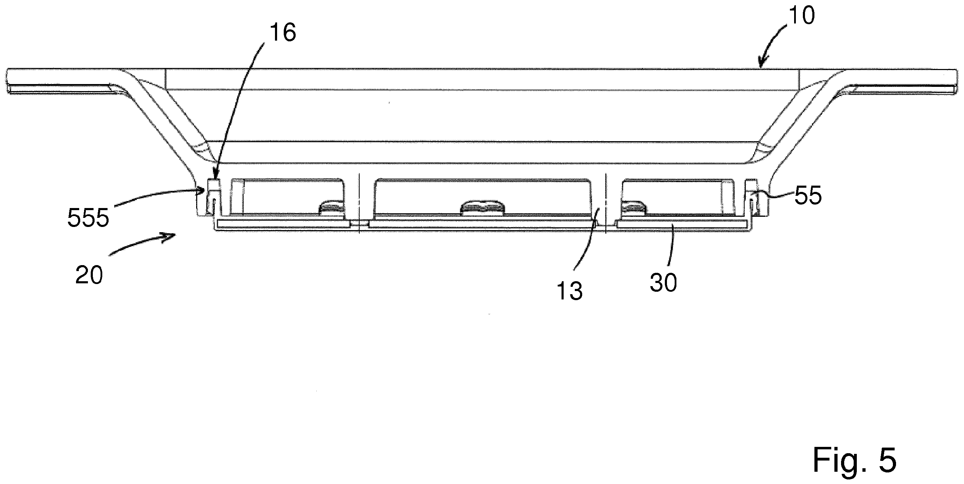

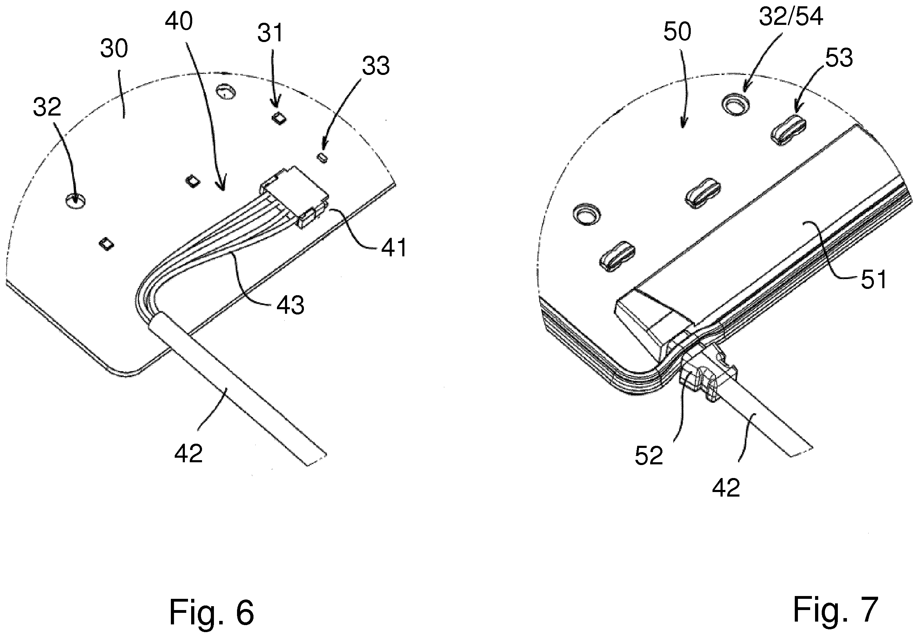

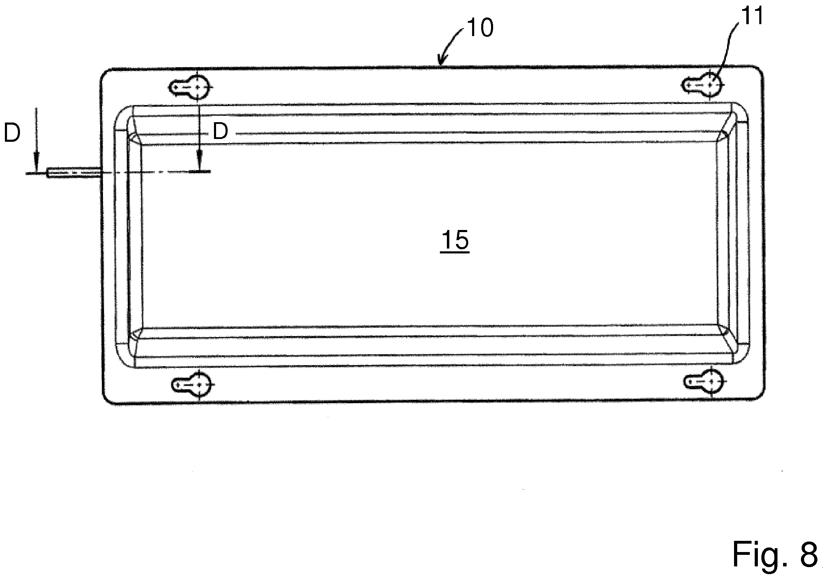

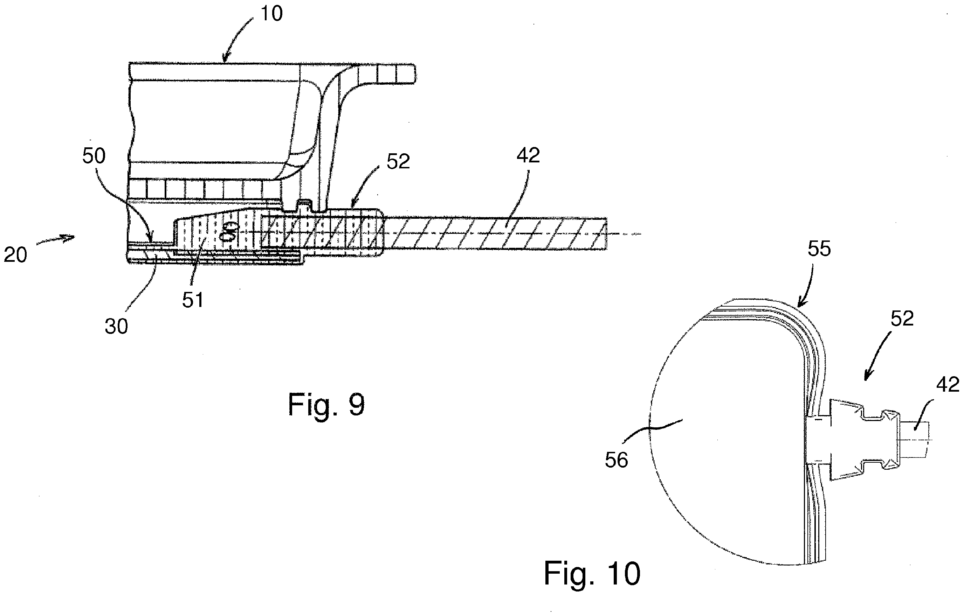

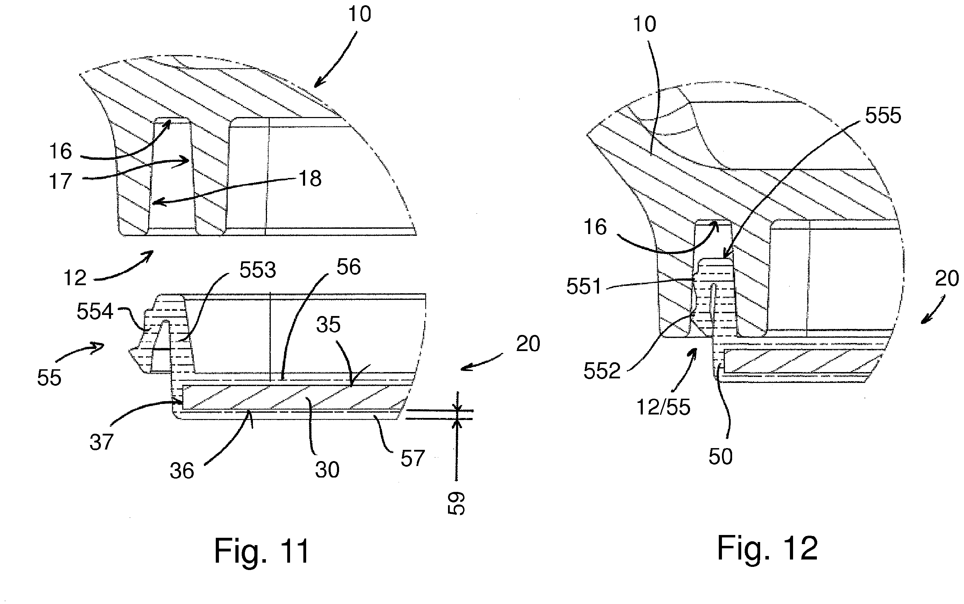

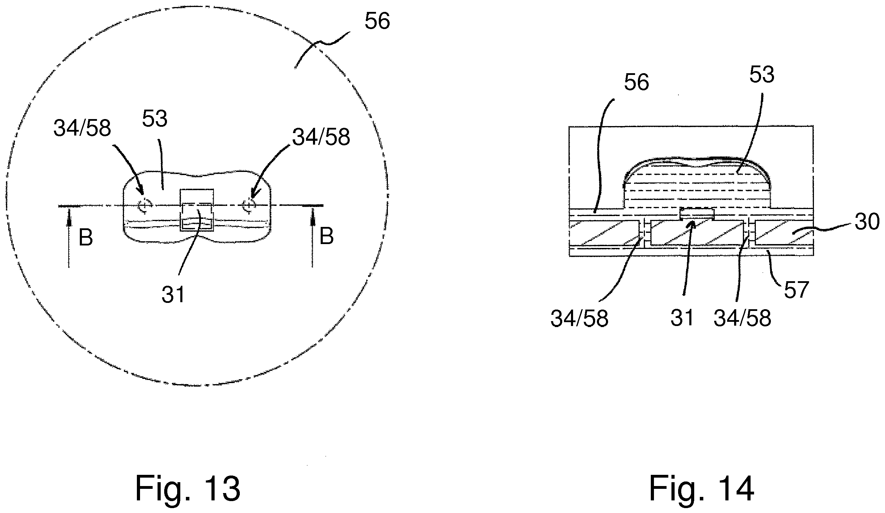

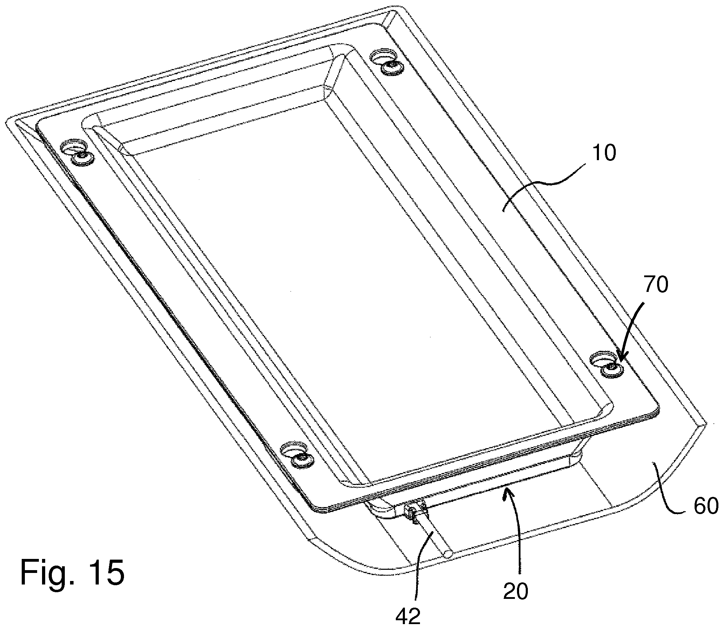

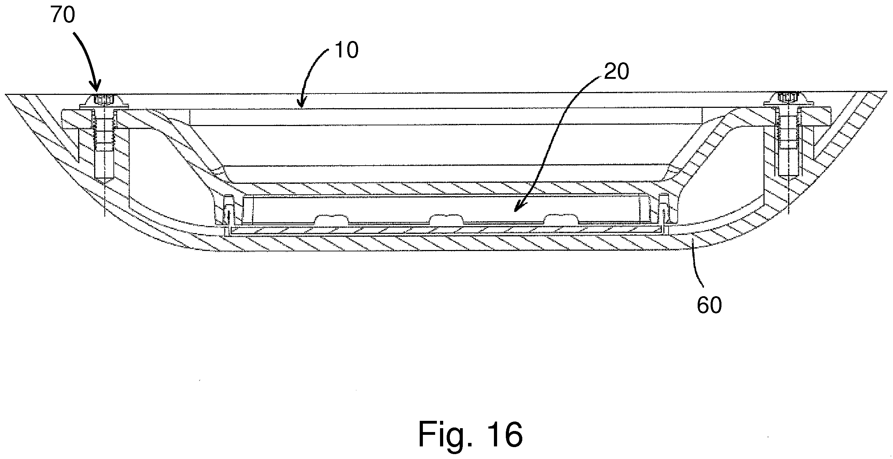

Eine Beleuchtungsvorrichtung nach den Fig. 1 bis 16 umfasst eine Abdeckung 10, ein an die Abdeckung 10 anlegbares Lichtmodul 20 und ein Gehäuse 60, welches aus Metall gebildet ist und zugleich als Kühlkörper dient.

Als weitere, nicht dargestellte Komponente der Beleuchtungsvorrichtung kann nach einem alternativen Ausführungsbeispiel der Erfindung ein an das Lichtmodul 20 anlegbarer, separater Kühlkörper vorgesehen sein, wobei das Gehäuse 60 den Kühlkörper beziehungsweise das Lichtmodul 20 umgreift. Insbesondere kann vorgesehen sein, dass das Gehäuse 60 den Kühlkörper aufnimmt und positioniert und dass der Kühlkörper über das Gehäuse 60 an dem Lichtmodul 20 festgelegt ist.

Die Abdeckung 10 weist eine rechteckige Grundform mit einem umlaufenden Rand auf. Der umlaufende Rand ist im Bereich gegenüberliegenden Längsseiten breiter ausgebildet als im Bereich der die Längsseiten verbindenden Schmalseiten. Im Bereich der Längsseiten sind zueinander beabstandet und gegenüberliegend jeweils zwei Befestigungslöcher 11 vorgesehen zum Festlegen der Abdeckung an dem Gehäuse 60 der Beleuchtungsvorrichtung oder an einem externen Befestigungskörper, beispielsweise einer Verkleidung oder einer Decke. Der Rand umschließt eine muldenförmige Ausnehmung der Abdeckung 10, welche einen im Wesentlichen ebenen und optikfreien transparenten Durchlassabschnitt 15 aufweist. Der transparente Durchlassabschnitt 15 ist auf einer dem Lichtmodul 20 zugewandten Flachseite von einer umlaufenden Nut 12 begrenzt. Zusätzlich ist an der umlaufenden Nut 12 eine Durchbrechung als Kabeldurchführung 14 ausgebildet. Verteilt im Bereich des Durchlassabschnitts 15 sind an der Abdeckung 10 sechs dem Lichtmodul 20 zugewandte Stifte 13 vorgesehen. Beispielsweise ist die Abdeckung aus Glas oder Kunststoff, bevorzugt PMMA, gebildet.

Das Lichtmodul 20 ist in einer Erstreckungsebene 21 flacherstreckt ausgebildet. Die Erstreckungsebene 21 ist durch einen Schaltungsträger 30, beispielsweise eine Platine definiert. An dem Schaltungsträger 30 sind matrixartig verteilt eine Mehrzahl von Leuchtdioden 31 vorgesehen. Die Leuchtdioden 31 sind im montierten Zustand der Beleuchtungsvorrichtung den Durchlassabschnitt 15 der Abdeckung 10 so zugewandt, dass Licht der Leuchtdioden 31 durch den Durchlassabschnitt 15 hindurch abgestrahlt wird. Zusätzlich sind an dem Schaltungsträger 30 verteilt insgesamt sechs Löcher 32 vorgesehen, welche der Aufnahme der an der Abdeckung 10 vorgesehen Stifte 13 dienen und insofern korrespondierend zu den Stiften 13 angeordnet sind. Im Zusammenwirken definieren die Löcher 32 und die Stifte 13 eine relative Position des Lichtmoduls 20 zu der Abdeckung 10. Die Löcher 32 dienen zugleich der Aufnahme und Positionierung des Schaltungsträgers 30 in der Spritzgießmaschine beim Herstellen der Silikonumspritzung 50.

Der Schaltungsträger 30 trägt des Weiteren einen Steckverbinder 41 eines elektrischen Anschlussmoduls 40. Mit dem Steckverbinder 41 verbundene elektrische Leiter 43, welcher zu einem Kabel 42 verbunden sind, dienen der elektrischen Kontaktierung des Lichtmoduls. An dem Schaltungsträger 30 sind ferner nicht dargestellte Zuleitungen zum elektrisch leitenden Verbinden der Leuchtdioden 31 mit dem Steckverbinder 41 vorgesehen. Zudem dient ein an dem Schaltungsträger 30 festgelegter NTC 33 zur Strombegrenzung beziehungsweise als Temperatursensor.

Den Schaltungsträger 30 mit den daran festgelegten Funktionskomponenten umgibt eine Silikonumspritzung 50. Die Silikonumspritzung 50 ist einstückig ausgebildet. Sie erstreckt sich über eine der Abdeckung 10 zugewandte optisch wirksame Vorderseite 35 des Schaltungsträgers 30 ebenso wie über eine zur Anlage des Gehäuses 60 beziehungsweise des Kühlkörpers ausgebildete Rückseite 36 und die Vorderseite 35 mit der Rückseite 36 verbindende Kantenflächen 37 des Schaltungsträges 30. Die Silikonumspritzung 50 realisiert eine Anschlussabdeckung 51 für das elektrische Anschlussmodul 40 mit einer das Kabel 42 umgebene Zugentlastung 52. Die Zugentlastung 52 ist so geformt, dass sie im montierten Zustand in die Kabeldurchführung 14 der Abdeckung 10 eingesetzt und dort formschlüssig festgelegt werden kann. Die Silikonumspritzung 50 definiert zudem die dem Leuchtdioden 31 zugeordneten Linsen 53. Es ist hierbei jeweils eine Linse 53 für jede Leuchtdiode 31 als integraler Bestandteil der Umspritzung 50 aus dem Silikonmaterial hergestellt. Insbesondere können die Leuchtdioden 31 auf eine Primäroptik verzichten. Die Linsen 53 dienen insofern als alleinige Optik. Optional können Optikelemente, beispielsweise eine Linsenstruktur, im Bereich des Durchlassabschnitts 15 der Abdeckung 10 realisiert sein. Optional können den Linsen 53 Reflektoren zugeordnet sein. Ein Reflektoreinsatz kann insofern beispielsweise eine Mehrzahl von Reflektoren bereitstellen.

Eine Aussparung in der Silikonumspritzung 50 ergibt sich allein im Bereich der an dem Schaltungsträger 30 vorgesehen Löcher 32. Die Silikonumspritzung 50 sieht insofern Freiräume 54 vor, welche das Einsetzen der als Teil der Abdeckung 10 realisierten Stifte 13 in die Löcher 32 des Schaltungsträgers 30 erlauben. Ansonsten überdeckt die Silikonumspritzung 50 den Schaltungsträger 30 mit den daran festgelegten Leuchtdioden 31, den Zuleitungen für die Leuchtdioden 31 und dem elektrischen Anschlussmodul 40 vollständig. Die Silikonumspritzung 50 definiert insofern einen Berührungsschutz und ein Kapselung und schützt zudem vor mechanischen Einflüssen beziehungsweise Beschädigung.

Durch das Vorsehen der Aussparung in der Silikonumspritzung 50 und die an dem Schaltungsträger 30 vorgesehenen Löcher 32 kann die Abdeckung 10 mit den daran vorgesehenen, verteilt angeordneten Stiften 13 oder andere Stützstrukturen an dem Lichtmodul 20 abgestützt werden. Es kann insbesondere vorgesehen sein, dass die Klemm- beziehungsweise Stützkräfte über die Stifte 13 übertragen werden, sodass die Dichtung im Bereich der Dichtwulst 55 und der umlaufenden Nut 12 im Wesentlichen kraftfrei erfolgt. Die Stifte 13 sorgen zudem dafür, dass das Lichtmodul 20 beziehungsweise der Schaltungsträger 30 des Lichtmoduls 20 vor einer unerwünschten beziehungsweise unzulässigen Durchbiegung geschützt ist. Zusätzlich kann eine Befestigung mittels einer Verschraubung durch die Löcher 32 realisiert werden.

Eine besonders vorteilhafte Verbindung der Silikonumspritzung 50 mit dem Schaltungsträger 30 ergibt sich durch das Vorsehen von mit Silikon ausgespritzten Verbindungsöffnungen 34 an dem Schaltungsträger 30. Die Verbindungsöffnungen 34 sind insbesondere benachbart zu den Leuchtdioden 31 vorgesehen. Durch das Füllen der Verbindungsöffnung 34 mit dem Silikonmaterial bildet sich ein Steg 58 als Teil der Silikonumspritzung 50, welcher eine der Vorderseite 35 des Schaltungsträgers 30 zugeordnete Vorderseite 56 der Silikonumspritzung 50 mit einer der Rückseite 36 des Schaltungsträgers 30 zugeordneten Rückseite 57 der Silikonumspritzung 50 stoffschlüssig verbindet. Es ergibt sich hierdurch zum einen eine gute, flächige Anlage der Silikonumspritzung 50 an dem Schaltungsträger 30. Zum anderen sind die Linsen 53 bezogen zur Position der Leuchtdioden 31 fixiert. Gemäß der Erfindung ist als Teil der Silikonumspritzung 50 eine dem Schaltungsträger 30 randseitig zugeordnete Dichtwulst 55 vorgesehen, welche in Richtung der Abdeckung 10 abragend ausgestaltet ist. Die Dichtwulst 55 ist in Bezug auf ihre Geometrie angepasst an die Geometrie der Nut 12. Die Dichtwulst 55 ist insbesondere im Querschnitt V-förmig realisiert mit einem der Vorderseite der Umspritzung 50 randseitig zugeordneten Verbindungsschenkel 553 und einem an den Verbindungsschenkel 553 angeformten freien Schenkel 554. In einem Scheitel 555 sind der Verbindungsschenkel 553 und der freie Schenkel 554 verbunden. Die Dichtwulst 55 ist zum einen aufgrund der Materialeigenschaften der Silikonumspritzung 50 und zum anderen durch einen zwischen den Schenkel 553, 554 gebildeten, im Querschnitt v-förmigen Freiraum elastisch verformbar ausgebildet. Die Dichtwulst 55 weist an dem freien Schenkel 554 auf einem dem Verbindungsschenkel 553 abgewandten Außenseite beabstandet zueinander zwei Dichtlippen 551, 552 als Ausformungen auf.

Nach einer alternativen, nicht dargestellten Ausführungsform der Erfindung kann die Dichtwulst 55 beispielsweise U-förmig ausgebildet sein. Beispielsweise kann ein an der Abdeckung 10 vorgesehener Steg in die Ausnehmung der Dichtwulst 55 eingesetzt werden zur Realisierung der Dichtung. Insofern ist das Dichtprinzip konstruktiv umgekehrt realisiert.

Gleiche Bauteile und Bauteilfunktionen sind durch gleiche Bezugszeichen gekennzeichnet.

Beim Ansetzen des Lichtmoduls 20 an die Abdeckung 10 wird die Dichtwulst 55 in die umlaufende Nut 12 der Abdeckung 10 eingesetzt. Es ist hierbei der Scheitel 555 beabstandet zu einem Nutgrund 16 der Nut 12 vorgesehen. Die Schenkel 553, 554 liegen an gegenüberliegenden Nutflanken 17, 18 der Nut 12 an. Die Nutflanken 17, 18 sind zueinander so angestellt, dass die Nut 12 sich in Richtung des Nutgrunds 16 verjüngt und bei der Aufnahme der Dichtwulst 55 die Dichtlippen 551, 552 an einer äußeren Nutflanke 18 der Nut 12 angelegt sind. Es ergibt sich insofern ein definierter Dichtbereich zwischen den Nutflanken 17, 18 und den Schenkeln 553, 554 der Dichtwulst 55. Zudem werden die bei der Montage der Beleuchtungsvorrichtung über die Befestigungslöcher 11 abgestützten Kräfte gleichmäßig und großflächig verteilt, so dass einer unzulässig hohen lokalen Belastung und einer Beschädigung der Dichtwulst 55 beziehungsweise einer Beeinträchtigung der Dichtwirkung vorgebeugt ist.

Im montierten Zustand ist zusätzlich die als Teil der Silikonumspritzung 50 ausgebildete Zugentlastung 52 in die Kabeldurchführung 14 der Abdeckung 10 eingesetzt.

Die Abdeckung 10 wird über eine Mehrzahl von durch die Befestigungslöcher 11 geführten Schrauben 70 mit dem Gehäuse 60 verbunden. Hierbei erfolgt die Zuordnung der Abdeckung 10 zu dem Gehäuse 60 so, dass das Lichtmodul 20 mit der Rückseite 57 der Silikonumspritzung 50 gegen eine Innenseite des Gehäuses 60 gedrückt wird. Die elastische Silikonumspritzung 50, welche im Bereich der Rückseite 57 bevorzugt eine Dicke 59 von maximal 1 mm aufweist, wird zur Realisierung eines guten Wärmetransfers auf das Gehäuse 60 komprimiert. Die Elastizität der Silikonumspritzung 50 begünstigt zugleich die flächige Anlage an dem Gehäuse 60.

Während das Metallgehäuse 60 eine Lebensdauer von beispielsweise 50 Jahren aufweist, beträgt eine Lebensdauer des Lichtmoduls 20 beispielsweise 10 Jahre oder 20 Jahre. Es muss insofern das Lichtmodul 20 während der Lebensdauer des Gehäuses 60 häufiger ausgetauscht werden. Zum Austausch wird das Lichtmodul 20 zusammen mit der Abdeckung 10 aus dem Gehäuse 60 entnommen. Die Demontage des Lichtmoduls 20 kann dann werkzeuglos erfolgen, da die Abdeckung 10 und das Lichtmodul 20 insbesondere über die in die Nut 12 eingesetzte Dichtwulst 55 miteinander verbunden sind. Das Recycling des Lichtmoduls 20 ist hierdurch vereinfacht.

### Bezugszeichenliste

- 10: Abdeckung
- 11: Befestigungsloch
- 12: Nut
- 13: Stift
- 14: Kabeldurchführung
- 15: Durchlassabschnitt
- 16: Nutgrund
- 17: Nutflanke
- 18: Nutflanke
- 20: Lichtmodul
- 21: Erstreckungsebene
- 30: Schaltungsträger
- 31: Leuchtdiode
- 32: Loch
- 33: NTC
- 34: Verbindungsöffnung
- 35: Vorderseite
- 36: Rückseite
- 37: Kantenfläche
- 40: Anschlussmodul
- 41: Steckverbinder
- 42: Kabel
- 43: Leiter
- 50: Silikonumspritzung
- 51: Anschlussabdeckung
- 52: Zugentlastung
- 53: Linse
- 54: Freiraum
- 55: Dichtwulst
- 56: Vorderseite
- 57: Rückseite
- 58: Steg
- 59: Dicke
- 60: Gehäuse
- 70: Schraube
- 551: Dichtlippe
- 552: Dichtlippe
- 553: Verbindungsschenkel
- 554: freier Schenkel
- 555: Scheitel

## Patentansprüche

1. Beleuchtungsvorrichtung mit einem Lichtmodul (20), umfassend
- einen mindestens teilweise ummantelten Schaltungsträger (30), welcher mindestens eine an dem Schaltungsträger (30) festgelegte Leuchtdiode (31) als Lichtquelle und mindestens eine der mindestens einen Leuchtdiode (31) zugeordnete Linse (53) zum Formen einer Lichtverteilung aufweist, und
- ein an dem Schaltungsträger (30) vorgesehenes elektrisches Anschlussmodul (40), wobei an dem Schaltungsträger (30) mindestens eine Zuleitung vorgesehen ist zum Verbinden der mindestens einen Leuchtdiode (31) mit dem elektrischen Anschlussmodul (40), und
- eine an das Lichtmodul (20) angelegten Abdeckung (10), welche einen transparenten Lichtdurchlassabschnitt (15) für das von der mindestens einen Leuchtdiode (31) abgestrahlte Licht aufweist,
- eine Ummantelung für den Schaltungsträger (30) mit einer umlaufenden Dichtwulst (55) wobei korrespondierend zu der Dichtwulst (55) an der Abdeckung (10) eine umlaufende eine Nut (12) ausbildende Ausformung vorgesehen ist, wobei die Dichtwulst (55) elastisch verformbar ausgebildet ist und in einem montierten Zustand an die Ausformung angesetzt und elastisch verformt ist
**dadurch gekennzeichnet, dass**
die Ummantelung als Silikonumspritzung (50) ausgebildet ist und dass die Dichtwulst
- randseitig an dem Schaltungsträger (30) angeordnet ist und in Richtung der Abdeckung 10 abragend ist,
- eine an die Geometrie der Nut (12) angepasste Geometrie hat,
- im Querschnitt V-förmig oder U-förmig ist und einen an der Vorderseite der Umspritzung (50) randseitig zugeordneten Verbindungsschenkel (553) und einem an den Verbindungsschenkel (553) angeformten freien Schenkel (554) hat, die in einem Scheitel (555) verbunden sind
- an dem freien Schenkel (554) auf einem dem Verbindungsschenkel (553) abgewandten Außenseite beabstandet zueinander zwei Dichtlippen (551, 552) als Ausformungen aufweist.

2. Beleuchtungsvorrichtung nach Anspruch 1, **dadurch gekennzeichnet, dass** der Scheitel (555) einem Nutgrund (16) der Nut (12) zugewandt ist.

3. Beleuchtungsvorrichtung nach Anspruch 1 oder 2, **dadurch gekennzeichnet, dass** die Nut (12) sich im Querschnitt in Richtung des Nutgrunds (16) verjüngt.

4. Beleuchtungsvorrichtung nach einem der Ansprüche 1 bis 3, **dadurch gekennzeichnet, dass** einander gegenüberliegende Nutflanken (17, 18) der Nut (12) flach und/oder eben ausgebildet sind.

5. Beleuchtungsvorrichtung nach einem der Ansprüche 1 bis 4, **dadurch gekennzeichnet, dass** die Dichtwulst (55) mit der Dichtlippe (551, 552) an wenigstens einer Nutflanke (17, 18) der Nut (12) anliegt.

6. Beleuchtungsvorrichtung nach einem der Ansprüche 1 bis 5, **dadurch gekennzeichnet, dass** der Verbindungsschenkel (553) dem Schaltungsträger zugwewandt ist an einer ersten Nutflanke (17) anliegt und dass der freien Schenkel (554) an einer zweiten Nutflanke (18) anliegt.

7. Beleuchtungsvorrichtung nach einem der Ansprüche 1 bis 6, **dadurch gekennzeichnet, dass** der Scheitel (555) der Dichtwulst (55) beabstandet zum Nutgrund (16) vorgesehen ist.

8. Beleuchtungsvorrichtung nach einem der Ansprüche 1 bis 7, **dadurch gekennzeichnet, dass** die Dichtwulst 55 im Querschnitt U-förmig ausgebildet ist und einen den an der Abdeckung (10) gebildeten Steg aufnimmt.

## Claims

1. Illumination device with a light module (20), comprising
- an at least partially covered circuit carrier (30) which comprises at least one light emitting diode (31) being fixed to the circuit carrier (30) as a light source and at least one lens (53) being associated with the at least one light emitting diode (31), for shaping a light distribution, and
- an electrical connection module (40) being provided at the circuit carrier (30), wherein at least one supply line is provided at the circuit carrier (30) for connecting the at least one light emitting diode (31) to the electrical connection module (40), and
- a cover (10) being attached to the light module (20) which has a transparent light transmission section (15) for the light emitted by the at least one light emitting diode (31),
- a sheath for the circuit carrier (30) with a circumferential sealing bead (55), wherein a circumferential molding forming a groove (12) corresponding to the sealing bead (55) is provided at the cover (10), wherein the sealing bead (55) is configured elastically deformable and is attached to the molding and is elastically deformed in a mounted state,
**characterized in that**
the sheath is formed as a silicon-overmolding (50) and that the sealing bead
- is arranged at the edge side of the circuit carrier (30) and protrudes in the direction towards the cover (10),
- has a geometry adapted to the geometry of the groove (12),
- is V-shaped or U-shaped in its cross-section and has a connecting leg (553) being arranged at an edge side at the front side of the overmolding (50) and has a free leg (554) being formed to the connecting leg (553), which both legs are connected in a vertex (555)
- has two mutually spaced sealing lips (551, 552) as moldings at the free leg (554) on an outer side facing away from the connecting leg (553).

2. Illumination device according to claim 1,
**characterized in that**
the vertex (555) faces towards a groove base (16) of the groove (12).

3. Illumination device according to claim 1 or 2,
**characterized in that**
the groove (12) tapers in the cross-section in the direction towards the groove base (16).

4. Illumination device according to one of claims 1 to 3,
**characterized in that**
mutually opposing groove flanks (17, 18) of the groove (12) are formed flat and/or planar.

5. Illumination device according to one of claims 1 to 4,
**characterized in that**
the sealing bead (55) abuts with the sealing lip (551, 552) to at least one groove flank (17, 18) of the groove (12).

6. Illumination device according to one of claims 1 to 5,
**characterized in that**
the connecting leg (553) faces the circuit carrier and abuts to a first groove flank (17) and **in that** the free leg (554) abuts to a second groove flank (18).

7. Illumination device according to one of claims 1 to 6,
**characterized in that**
the vertex (555) of the sealing bead (55) is provided at a distance from the groove base (16).

8. Illumination device according to one of claims 1 to 7,
**characterized in that**
the sealing bead (55) has a U-shaped cross-section and receives a land being formed on the cover (10).

## Revendications

1. Dispositif d'éclairage avec un module lumineux (20), comprenant :
- une carte de circuits (30) au moins partiellement enveloppée, qui présente au moins une diode électroluminescente (31) fixée sur la carte de circuits (30) et servant de source lumineuse et au moins une lentille (53) associée à l'au moins une diode électroluminescente (31) pour répartir la lumière, et
- un module de raccordement électrique (40) prévu sur la carte de circuits (30), au moins une ligne d'alimentation étant prévue sur la carte de circuits (30) pour connecter l'au moins une diode électroluminescente (31) au module de raccordement électrique (40), et
- une couverture (10) posée sur le module lumineux (20), qui présente une partie de passage de la lumière (15) transparente à la lumière émise par l'au moins une diode électroluminescente (31),
- une enveloppe pour la carte de circuits (30) avec un bourrelet d'étanchéité (55) sur la circonférence, une structure circonférentielle formant une gorge (12) étant prévue sur la couverture (10) en correspondance du bourrelet d'étanchéité (55), lequel bourrelet d'étanchéité (55) est déformable de façon élastique et peut être posé sur la structure et déformé dé façon élastique dans un état monté,
**caractérisé en ce que** l'enveloppe est conformée comme un enrobage de silicone injecté (50) et **en ce que** le bourrelet d'étanchéité
- est disposé sur le bord de la carte de circuits (30) et dépasse en direction de la couverture (10),
- possède une géométrie adaptée à celle de la gorge (12),
- a une section en forme de V ou de U et possède un bras de liaison (553) associé sur le bord à l'enrobage injecté (50) sur le côté antérieur et un bras libre (554) formé sur le bras de liaison (553), lesquels bras sont reliés à un sommet (555),
- présente sur le bras libre (554) sur un côté extérieur tourné à l'opposé du bras de liaison (553), à distance l'une de l'autre, deux lèvres d'étanchéité (551, 552) formées à partir de celui-ci.

2. Dispositif d'éclairage selon la revendication 1, **caractérisé en ce que** le sommet (555) est tourné vers un fond de gorge (16) de la gorge (12).

3. Dispositif d'éclairage selon la revendication 1 ou 2, **caractérisé en ce que** la section de la gorge (12) diminue en direction du fond de gorge (16).

4. Dispositif d'éclairage selon l'une des revendications 1 à 3, **caractérisé en ce que** des flancs de gorge (17, 18) de la gorge (12) se faisant face ont une forme plate et/ou plane.

5. Dispositif d'éclairage selon l'une des revendications 1 à 4, **caractérisé en ce que** le bourrelet d'étanchéité (55) repose par la lèvre d'étanchéité (551, 552) sur au moins un flanc de gorge (17, 18) de la gorge (12).

6. Dispositif d'éclairage selon l'une des revendications 1 à 5, **caractérisé en ce que** le bras de liaison (553) est tourné vers la carte de circuits et repose sur un premier flanc de gorge (17) et **en ce que** le bras libre (554) repose sur un deuxième flanc de gorge (18).

7. Dispositif d'éclairage selon l'une des revendications 1 à 6, **caractérisé en ce que** le sommet (555) du bourrelet d'étanchéité (55) est prévu à distance du fond de gorge (16).

8. Dispositif d'éclairage selon l'une des revendications 1 à 7, **caractérisé en ce que** le bourrelet d'étanchéité (55) est en forme de U en section et reçoit une ailette formée sur la couverture (10).
